# EUROPEAN PATENT SPECIFICATION

(11) **EP 4 174 507 B1**
(45) Date of publication and mention of the grant of the patent: **09.09.2026**
(21) Application number: 22828585.4
(22) Date of filing: 21.04.2022
(51) Int. Cl.: G01R 31/52, G01R 31/382, G01R 31/396, G01R 31/364, H01M 10/42, H01M 50/583, H02H 7/18, H02H 3/087, H02J 7/60, H02H 3/04, H01M 10/48

(54) **BATTERY PROTECTION DEVICE**
BATTERIESCHUTZVORRICHTUNG
DISPOSITIF DE PROTECTION DE BATTERIE

(30) Priority: 25.06.2021 KR 20210082830
(43) Date of publication of application: 03.05.2023
(73) Proprietor: LG Energy Solution, Ltd., Seoul 07335 (KR)
(72) Inventor: JEONG, Suyeup, Daejeon 34122 (KR); KIM, Minkyu, Daejeon 34122 (KR)
(74) Representative: Hoffmann Eitle
(86) International application number: PCT/KR2022/005726
(87) International publication number: WO 2022/270736

(56) References cited:
- EP-A2- 0 588 529
- EP-B1- 1 724 899
- WO-A1-2012/143619
- CN-Y- 201 274 274
- DE-A1- 102017 115 785
- JP-A- 2010 230 678
- JP-A- 2018 021 880
- JP-A- 2018 054 390
- KR-A- 20180 037 812
- KR-A- 20200 042 238
- US-A1- 2010 072 950

## Description

### [Technical Field]

This application claims priority to and the benefit of Korean Patent Application KR20210082830A filed in the Korean Intellectual Property Office on June 25, 2021.

The present invention relates to a battery protection apparatus, and more particularly, to a battery protection apparatus using a high-resistance parallel structure.

### [Background Art]

An energy storage system relates to renewable energy, a battery that stores electric power, and grid power. Recently, as the spread of smart grid and renewable energy is expanding and the efficiency and the stability of the power system are emphasized, a demand for energy storage systems for power supply and demand control and power quality improvement is increasing. Depending on a purpose of use, energy storage systems may have different output and capacity. In order to configure a large-capacity energy storage system, a plurality of battery systems may be connected.

In providing services related to an energy storage system, it is necessary to monitor and manage state of the battery. For this, the energy storage system usually provides information on a battery system voltage and existence of a blown battery fuse. For example, when a 17-stage battery rack is used as a battery, the voltages of 238 battery cells connected in series are respectively measured and summed to calculate the system voltage. Here, because the number of battery cells is large, an error generated by decimal point round-down calculation in a process of calculating individual voltages may be increased when the voltages for each battery cells are summed. In addition, it is not easy to determine whether a problem is caused from a fuse or from any another device when the battery is not charging or discharging.

As described, in the existing method of managing state of the battery, errors may occur in measuring the system voltage. Furthermore, it is not easy to detect immediately if a fuse in a battery system is blown.

DE 10 2017 115785 A1 relates to a protection circuit 6 disposed between the voltage measurement module 7 and the battery pack 1 and used to protect the voltage measurement module 7. The protection circuit 6 consists of a pair of fuses F1 and F2. Each of the pair of fuses F1 and F2 constitutes an electronic component that is melted and broken in accordance with an overcurrent and has a predetermined internal resistance (a protection resistance value Rh). These protective resistance values Rh change in a time series according to the operational states of the fuses F1 and F2. The voltage measurement module 7 consists of a pair of low-pass filters L1 and L2, a pair of discharge resistors R1 and R2, and a cell voltage measurement IC 7a.

WO 2012/143619 A1 relates to electronic monitoring of fuses. Referring to fig. 1, the main circuit is created between the positive (+) and negative (-) supply poles of the DC voltage circuit, including the load 8 and the fuses (7a, 7b) which protect the circuit; the monitored fuse 7a has been connected to the positive pole of supply, and the monitored fuse 7b to the negative pole. An auxiliary voltage source (1a,1b) has been connected between the supply poles (+) and (-) to feed the reference voltage (UREFa,UREFb) to the inverting input (-) of the comparator (4a,4b) and the auxiliary voltages required by the comparator (4a,4b), the logic element 5 and the indication element 6.

CN 201 274 274 Y discloses that after fuse RD fusing, the testing circuit no-voltage offers the base stage of triode T, and triode T ends, and LED extinguishes indicate fuse RD to be damaged.

EP 0 588 529 A2 relates to devices indicating the status of a fuse or circuit breaker and, more particularly, devices providing a visual or audible indication of such. As long as fuse 103 is intact, and switch 104 is in a closed position, current flows through LED 105, and resistor 106, thereby causing LED 105 to illuminate. Resistor 106 serves to limit the current passing through LED 105. Light from LED 105 causes photo-transistor 109 to be placed in a non-conducting state, thereby prohibiting current from flowing through limiting resistor 110 and alarm LED 111. As a result, alarm LED 111 is not illuminated (an indication that fuse 103 is intact). If fuse 103 fails (i.e., blows), current is prohibited from flowing through LED 105 and resistor 106, and as a result LED 105 is not illuminated. Without incident light from LED 105, phototransistor 109 is placed in a conducting state, and current flows through limiting resistor 110 and alarm LED 111. This causes alarm LED 111 to illuminate and provide a visual indication that fuse 103 has blown.

JP 2018 021880 A relates to an overvoltage detection unit 34 as illustrated in figure 3, including a voltage dividing circuit 41, a threshold voltage outputting unit 42, a comparator 43.

US 2010/072950 A1 relates to an assembled battery system comprising: a charge/discharge controller which is connected to assembled battery so as to control a charge electrical power supplied to the assembled battery and/or a discharge electrical power supplied from the assembled battery.

### [Summary]

### [Technical Problem]

Accordingly, example embodiments of the present disclosure are provided to substantially obviate one or more problems due to limitations and disadvantages of the related art.

Embodiments of the present disclosure provide a battery protection apparatus including the apparatus for detecting battery state.

### [Technical Solution]

In view of the above, the present invention proposes an apparatus as defined by claim **1.** In order to achieve the objective of the present disclosure, the apparatus comprises a first fuse connected to a positive terminal of a battery; a second fuse connected to a negative terminal of the battery; a high resistance resistor connected to the first fuse and the second fuse and disposed in parallel with the battery; a sensor configured to measure a current flowing through the high-resistance resistor or a voltage applied to the high-resistance resistor; and a controller configured to determine a system voltage and determine whether any of the first and second fuses is blown based on the current measured or the voltage measured.

In the embodiment, the sensor may be a current sensor positioned between the high resistance resistor and the first fuse and connected in series with the high resistance resistor or positioned between the high resistance resistor and the second fuse and connected in series with the high resistance resistor.

In addition, the sensor may be a voltage sensor connected in parallel with the high resistance resistor to measure the voltage applied to the high resistance resistor.

In the embodiment, the controller may be included in a battery management system (BMS) that manages a battery state.

The controller may also be configured to determine that at least one of the first fuse and the second fuse is blown when the current value measured by the current sensor is zero.

Furthermore, the controller may be configured to calculate a system voltage provided by the battery using the current value measured by the current sensor and the resistance value of the high resistance resistor.

The controller may be configured to determine that the fuse is blown when the voltage value measured by the voltage sensor is zero.

The controller may be configured to determine the voltage measured by the voltage sensor as a system voltage provided by the battery.

Further embodiments are defined in the dependent claims.

### [Advantageous Effects]

According to the embodiment of the present disclosure with applying a high-resistance parallel structure, it is possible to provide a voltage information of the battery system and information on whether a fuse is blown, at low cost.

### [Brief Description of the Drawings]

Example embodiments of the present invention will become more apparent by describing in detail example embodiments of the present invention with reference to the accompanying drawings, in which:
FIG. 1 is a block diagram of an energy storage system to which the present invention may be applied.
FIG. 2 is a block diagram of a conventional battery state monitoring device.
FIG. 3 is a block diagram of an apparatus for detecting battery state according to an embodiment of the present invention.
FIG. 4 shows an example of determining system voltage information in an apparatus for detecting battery state according to an embodiment of the present invention.
FIG. 5 shows an example of checking whether a fuse is blown in the apparatus for detecting battery state according to an embodiment of the present invention.
FIG. 6 is a block diagram of an apparatus for detecting battery state according to another embodiment of the present invention.

### [Detailed Description]

Example embodiments of the present invention are disclosed herein. However, specific structural and functional details disclosed herein are merely representative for purposes of describing example embodiments of the present invention, and example embodiments of the present invention may be embodied in many alternate forms and should not be construed as limited to example embodiments of the present invention set forth herein.

Accordingly, while the invention is susceptible to various modifications and alternative forms, specific embodiments thereof are shown by way of example in the drawings and will herein be described in detail. It should be understood, however, that there is no intent to limit the invention to the particular forms disclosed, but on the contrary, the invention is to cover all modifications, equivalents, and alternatives falling within the scope of the invention as defined in the appended claims.

Like numbers refer to like elements throughout the description of the figures.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes any and all combinations of one or more of the associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (i.e., "between" versus "directly between", "adjacent" versus "directly adjacent", etc.).

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises", "comprising,", "includes" and/or "including", when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It should also be noted that in some alternative implementations, the functions/acts noted in the blocks may occur out of the order noted in the flowcharts. For example, two blocks shown in succession may in fact be executed substantially concurrently or the blocks may sometimes be executed in the reverse order, depending upon the functionality/acts involved.

Hereinafter, exemplary embodiments of the present invention will be described in detail with reference to the accompanying drawings.

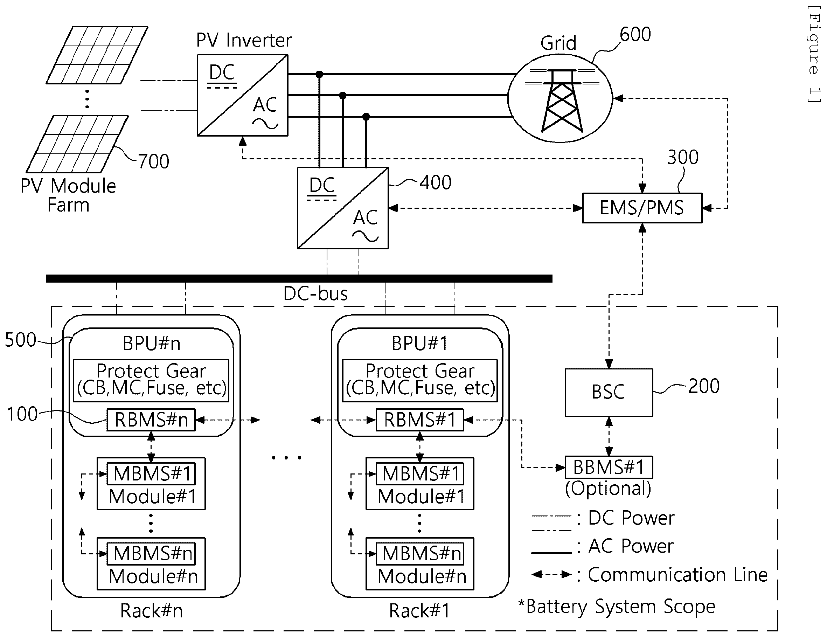

FIG. 1 is a block diagram of an energy storage system to which the present invention may be applied.

In an energy storage system (ESS), typically a battery cell is a minimum unit of storing energy or power. A series/parallel combination of battery cells may form a battery module, and a plurality of battery modules may form a battery rack. That is, a battery rack can be a minimum unit of a battery system as a series/parallel combination of battery modules. Here, depending on a device or a system in which the battery is used, a battery rack may be referred to as a battery pack.

Referring to FIG. 1, a battery rack may include a plurality of battery modules and a Battery Protection Unit (BPU) 500 or a protection device. The battery rack can be monitored and controlled through a rack battery management system (BMS) or RBMS 100. The RBMS 100 may monitor a current, a voltage and a temperature of each battery rack to be managed, calculate a State Of Charge (SOC) of the battery based on a monitoring result, and control charging and discharging.

The battery protection unit (BPU) 500 is a device for protecting the battery from an abnormal current and a fault current in a battery rack. The BPU may include a main contactor (MC), a fuse, a circuit breaker (CB) or a Disconnect Switch(DS), and the like. The BPU may control the battery system rack by rack through on/off controlling the main contactor based on a control from the Rack BMS. The BPU may also protect the battery from a short circuit current using a fuse in the event of a short circuit. As such, the battery system can be controlled through a protection device such as a BPU or a switchgear.

A battery section controller (BSC) 200 is located in each battery section which includes a plurality of batteries, peripheral circuits, and devices to monitor and control objects such as a voltage, a current, a temperature, and a circuit breaker. The battery section controller is an uppermost control device in a battery system including at least one of battery bank with a plurality of battery packs. The battery section controller may also be used as a control device in a battery system having a plurality of bank level structures.

A power conversion system (PCS) 400 installed in each battery section controls the power supplied from the outside and the power supplied from the battery section to the outside, therby controlling charging and discharging of the battery. The power convertion system may include a DC/AC inverter. In case the energy storage system interworks with a photovoltaic system (PV), the system may include a PV inverter.

Meanwhile, the output of each BPU may be connected to the power conversion system 400 through a DC bus, and the power conversion system 400 may be connected to the power grid 600. In addition, an Energy Management System (EMS)/ Power Management System (PMS) 300 may be configured to manage the energy storage system as a whole.

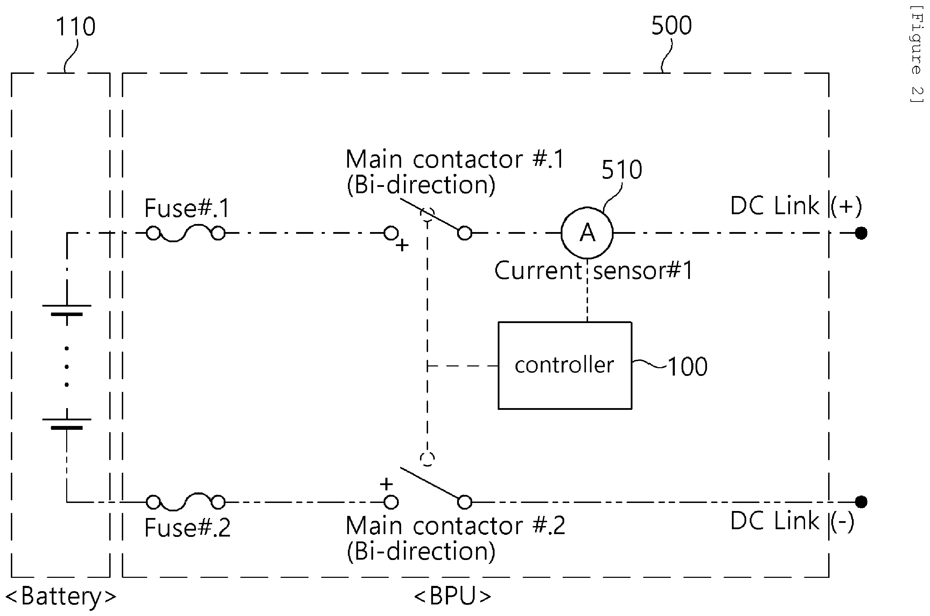

FIG. 2 is a block diagram of a conventional battery state monitoring device.

A device with a configuration as shown in FIG. 2 is conventionally used in order to monitor a battery state of an energy storage system.

Referring to FIG. 2, a first fuse is connected to the positive electrode of a series of batteries, and a second fuse is connected to the negative electrode of the battery. The other end of the first fuse is connected to the first main contactor, and the other end of the second fuse is connected to the second main contactor. Here, the first main contactor is connected to the positive terminal of the DC link and the second main contactor is connected to the negative terminal of the DC link.

In the conventional battery state monitoring structure, a current sensor 510 is arranged between the main contactor and the DC link, and a rack BMS estimates a sum of battery cell voltages based on the current value measured by the current sensor 510. In this structure, a case when a fuse is blown cannot be detected. It can be indirectly inferred that an error or problem has occurred in a fuse or any other components after recognizing that any current does not flow in response to a battery charge/discharge command. Thus, a normal maintenance manager cannot quickly and easily find out why charging and discharging does not work properly unless he/she is an experienced maintenance engineer.

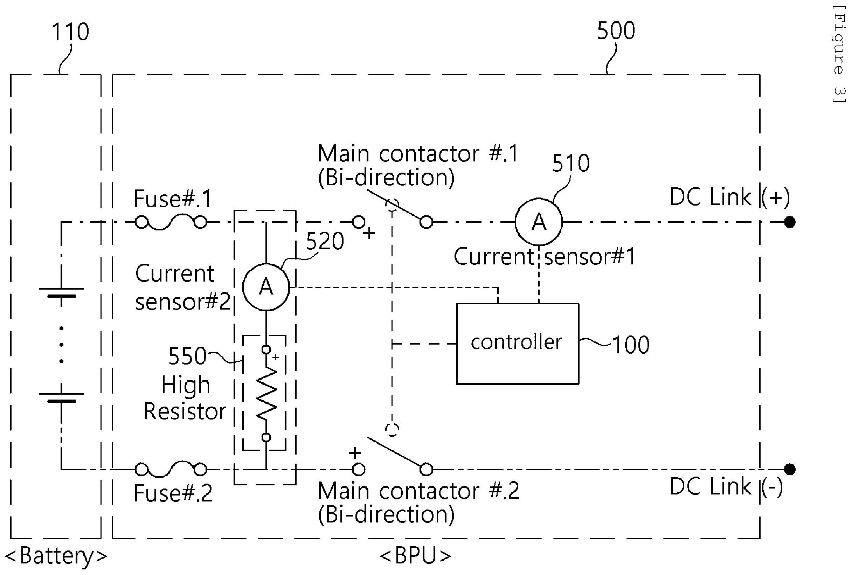

The present invention is proposed to solve this problem, and through the embodiments shown in FIGs. 3 to 6, it is possible to simultaneously check the voltage information of the system and whether a fuse is blown.

FIG. 3 is a block diagram of an apparatus for detecting battery state according to an embodiment of the present invention.

Referring to FIG. 3, an apparatus for detecting battery state according to an embodiment of the present invention may comprise a first fuse connected to a positive terminal of a battery, a second fuse connected to a negative terminal of the battery, a high resistance resistor 550 connected to the first fuse and the second fuse and disposed in parallel with the battery, a sensor 520 configured to measure a current flowing through the high-resistance resistor, and a controller 100 configured to determine a system voltage and determine whether any of the fuses is blown from the measured current.

Here, the controller 100 may be a Rack BMS or may be included in the Rack BMS as a part of the Rack BMS.

In this embodiment, the sensor 520 may be a current sensor positioned between the high resistance resistor and the first fuse and may be connected in series with the high resistance resistor. In addition, the sensor may be a current sensor positioned between the high resistance resistor and the second fuse and may be connected in series with the high resistance resistor.

In the embodiment of the present invention shown in FIG. 3, a high resistance resistor 550 may be positioned between a contact point of the first fuse and the first main contactor and a contact point of the second fuse and the second main contactor and may be arranged in parallel with the battery 110.

A fuse is one of the main components of a battery protection device. It is a protection device that can be passively disconnected to protect the battery when a short-circuit current occurs and is a one-time component that is essential for periodic replacement during use. A main contactor is an electrical switchgear, generally called as a magnetic contactor. The DC link must be closed to the ESS main circuits to enable charging and discharging of the battery.

Here, the resistance value of the high resistance resistor may be several megaohms (MQ). In the present invention, the high-resistance resistor is connected in parallel with the battery so that a small current of several mA flows through the high-resistance resistor and the small current is measured through the current sensor 520 connected in series with the high-resistance resistor. The controller may analyze the measured small current value and get information on a system voltage and information on whether fuse 1 or fuse 2 is blown. Accordingly, the current sensor 510 that used to be arranged in a conventional device may not necessarily be used.

The apparatus for detecting battery state according to the present invention may use the element 550 having high resistance and let only a small current flow through the element, thereby monitoring the battery state without significantly affecting system-specific functions of battery charging and discharging.

Furthermore, referring to FIG. 3, a battery protection apparatus 500 according to an embodiment of the present invention includes: a first fuse connected to a positive terminal of a battery; a second fuse connected to a negative terminal of the battery; a first main contactor configured to control a connection between the first fuse and the power conversion system; a second main contactor configured to control a connection between the second fuse and the power conversion system; a high resistance resistor 550 connected to the first fuse and the second fuse and disposed in parallel with the battery; a sensor 520 configured to measure a current flowing through the high-resistance resistor or a voltage applied to the high-resistance resistor; and a controller 100 configured to determine a system voltage and determine whether any of the fuses is blown from the measured current or measured voltage.

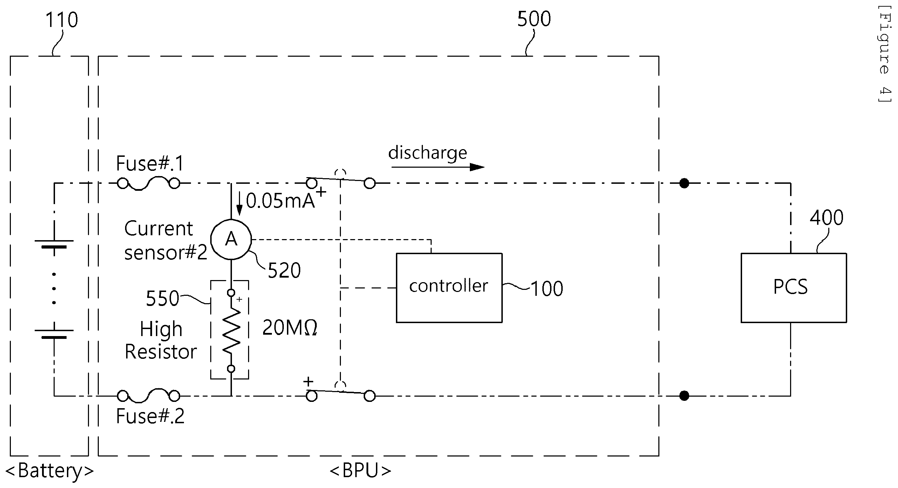

FIG. 4 shows an example of determining system voltage information in an apparatus for detecting battery state according to an embodiment of the present invention.

In the example shown in FIG. 4, a method for calculating a system voltage value using a current flowing through the high resistance resistor without knowing the system voltage provided by the battery. For example, in case that a resistance value of the high resistance resistor used in FIG. 4 is 20 megaohms (MΩ) and a measured current flowing through the high resistance resistor is 0.05 mA, the system voltage can be calculated as 0.05m * 20M = 1000 (V) using the V = IR formula.

As described, a high-resistance resistor is connected in parallel with the battery so that a small current of several mA flows through the high-resistance resistor, and the small current is measured through a current sensor 520 connected in series with the high-resistance resistor. The measured small current value can be analyzed by a controller 100 to determine the battery system voltage and whether a fuse therein is blown.

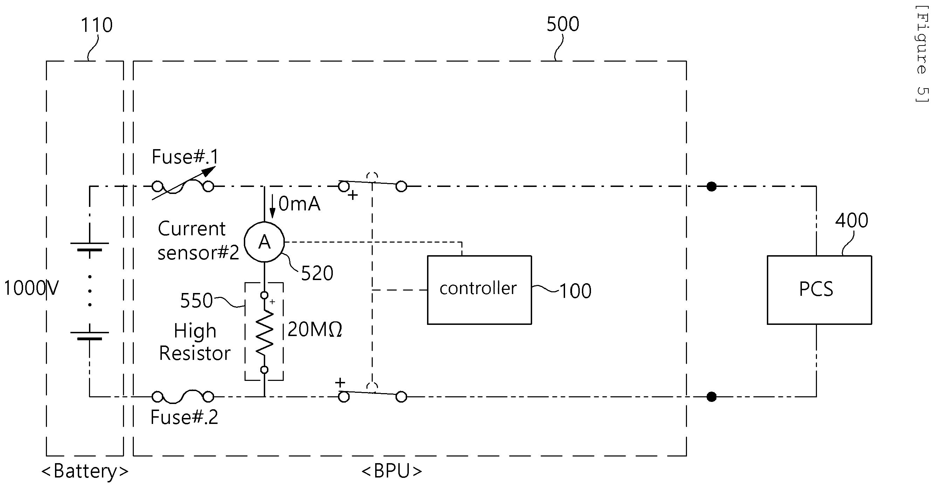

FIG. 5 shows an example of checking whether a fuse is blown in the apparatus for detecting battery state according to an embodiment of the present invention.

FIG. 5 shows an example case in which any current cannot be detected by a current sensor, that is, a current value with zero or close to zero is measured. In this case, the controller 100 may determine, from the current value measured by the current sensor, that one of the fuses (Fuse 1 or Fuse 2) is blown.

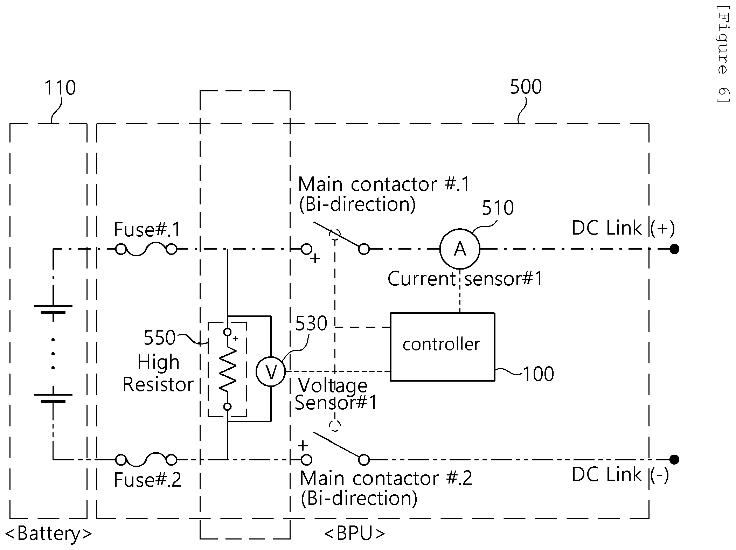

FIG. 6 is a block diagram of an apparatus for detecting battery state according to another embodiment of the present invention.

In another embodiment of the present invention shown in FIG. 6, a high resistance resistor 550 is provided between a contact point of the first fuse and the first main contactor and a contact point between the second fuse and the second main contactor, and is connected in parallel with the battery 110. Here, the resistance value of the high resistance resistor may be several megaohms (MQ).

That is, the apparatus for detecting battery state according to the present invention may comprise: a first fuse connected to a positive terminal of a battery; a second fuse connected to a negative terminal of the battery; a high resistance resistor 550 connected to the first fuse and the second fuse and disposed in parallel with the battery; a sensor 530 configured to measure a voltage applied to the high-resistance resistor; and a controller 100 configured to determine a system voltage and determine whether any of the fuses is blown from the measured voltage. In the embodiment, the sensor may be a voltage sensor connected in parallel with the high resistance resistor to measure a voltage applied to the high resistance resistor.

In the embodiment of FIG. 6, a voltage applied to the high resistance resistor may be measured by a voltage sensor 530 connected in parallel with the high resistance resistor.

The voltage value applied to the high resistance resistor measured by the voltage sensor 530, when the fuses operate normally, may be the same as or similar to the system voltage value which is a sum of the voltage values of a plurality of batteries connected in series. In case a fuse is blown, the voltage applied to the high resistance resistor would be close to zero.

That is, when a voltage value measured by the voltage sensor is a normal voltage value that can be expected from the battery system (for example, in a case of a 17 module - stage rack in which a battery cell voltage is 4.2V, the voltage output by the battery rack can be 999.6V since a module has a voltage value of 58.8V when SOC is 100%.), the controller 100 may determine the measured voltage as the system voltage. On the othe hand, the controller 100 may determine that a fuse is blown when the voltage measured by the voltage sensor is close to zero.

As described above, it is possible to economically implement the functions of checking a battery system voltage and checking state of a battery fuse through the high-resistance parallel structure provided by the embodiments of the present invention.

The embodiments of the present disclosure may be implemented as program instructions executable by a variety of computers and recorded on a computer readable medium. The computer readable medium may include a program instruction, a data file, a data structure, or a combination thereof. The program instructions recorded on the computer readable medium may be designed and configured specifically for the present disclosure or can be publicly known and available to those who are skilled in the field of computer software.

Examples of the computer readable medium may include a hardware device such as ROM, RAM, and flash memory, which are specifically configured to store and execute the program instructions. Examples of the program instructions include machine codes made by, for example, a compiler, as well as high-level language codes executable by a computer, using an interpreter. The above exemplary hardware device can be configured to operate as at least one software module in order to perform the embodiments of the present disclosure, and vice versa.

While the example embodiments of the present invention and their advantages have been described in detail, it should be understood that various changes, substitutions and alterations may be made herein without departing from the scope of the invention.

## Claims

1. A battery protection apparatus (500) in an energy storage system including a battery, the battery protection apparatus comprising:
a first fuse adapted to be connected to a positive terminal of a battery;
a second fuse adapted to be connected to a negative terminal of the battery;
**characterised by**:
a first main contactor configured to control a connection between the first fuse and a positive terminal of a DC link;
a second main contactor configured to control a connection between the second fuse and a negative terminal of the DC link;
a high resistance resistor (550) connected to the first fuse and the second fuse and disposed in parallel with the battery; wherein the high resistance resistor (550) is provided between a contact point of the first fuse and the first main contactor and a contact point between the second fuse and the second main contactor;
a sensor configured to measure a current flowing through the high-resistance resistor or a voltage applied to the high-resistance resistor; and
a controller configured to determine whether any of the first and second fuses is blown from the measured current or measured voltage,
wherein the resistance of the high resistance resistor (550) is configured such that system-specific functions of battery charging and discharging are not significantly affected by the high resistance resistor (550).

2. The battery protection apparatus of claim **1,** wherein the sensor is a current sensor (520) positioned between the high resistance resistor and the first fuse and connected in series with the high resistance resistor (550) or positioned between the high resistance resistor and the second fuse and connected in series with the high resistance resistor.

3. The battery protection apparatus of claim 1, wherein the sensor is a voltage sensor (530) connected in parallel with the high resistance resistor (550) to measure a voltage applied to the high resistance resistor.

4. The battery protection apparatus of claim 1, further including a battery management system (BMS), wherein the controller is included in the battery management system (BMS) that manages a battery state.

5. The battery protection apparatus of claim 2, wherein the controller is configured to determine that at least one of the first fuse and the second fuse is blown when the current value measured by the current sensor is zero.

6. The battery protection apparatus of claim 2, wherein the controller is configured to calculate a system voltage provided by the battery using the current value measured by the current sensor and the resistance value of the high resistance resistor.

7. The battery protection apparatus of claim 3, wherein the controller is configured to determine that at least one of the first fuse and the second fuse is blown when the voltage value measured by the voltage sensor is zero.

8. The battery protection apparatus of claim 3, wherein the controller is configured to determine the voltage measured by the voltage sensor as a system voltage provided by the battery.

## Patentansprüche

1. Batterieschutzeinrichtung (500) in einem Energiespeichersystem, das eine Batterie einschließt, wobei die Batterieschutzeinrichtung Folgendes umfasst:
eine erste Schmelzsicherung, die so angepasst ist, dass sie mit einem positiven Anschluss einer Batterie verbunden wird;
eine zweite Schmelzsicherung, die so angepasst ist, dass sie mit einem negativen Anschluss der Batterie verbunden wird;
**gekennzeichnet durch**:
einen ersten Hauptschütz, der so ausgebildet ist, dass er eine Verbindung zwischen der ersten Schmelzsicherung und einem positiven Anschluss eines Zwischenkreises steuert;
einen zweiten Hauptschütz, der so ausgebildet ist, dass er eine Verbindung zwischen der zweiten Schmelzsicherung und einem negativen Anschluss des Zwischenkreises steuert;
einen hochohmigen Widerstand (550), der mit der ersten Schmelzsicherung und der zweiten Schmelzsicherung verbunden ist und parallel zu der Batterie angeordnet ist; wobei der hochohmige Widerstand (550) zwischen einem Kontaktpunkt der ersten Schmelzsicherung und des ersten Hauptschützes und einem Kontaktpunkt zwischen der zweiten Schmelzsicherung und dem zweiten Hauptschütz bereitgestellt ist;
einen Sensor, der so ausgebildet ist, dass er einen durch den hochohmigen Widerstand fließenden Strom oder eine an den hochohmigen Widerstand angelegte Spannung misst; und
eine Steuereinheit, die so ausgebildet ist, dass sie aus dem gemessenen Strom oder der gemessenen Spannung bestimmt, ob eine der ersten und zweiten Schmelzsicherungen durchgebrannt ist,
wobei der Widerstandswert des hochohmigen Widerstands (550) derart ausgebildet ist, dass systemspezifische Funktionen des Ladens und Entladens der Batterie durch den hochohmigen Widerstand (550) nicht wesentlich beeinträchtigt werden.

2. Batterieschutzeinrichtung nach Anspruch 1, wobei der Sensor ein Stromsensor (520) ist, der zwischen dem hochohmigen Widerstand und der ersten Schmelzsicherung positioniert ist und in Reihe mit dem hochohmigen Widerstand (550) verbunden ist oder zwischen dem hochohmigen Widerstand und der zweiten Schmelzsicherung positioniert ist und in Reihe mit dem hochohmigen Widerstand verbunden ist.

3. Batterieschutzeinrichtung nach Anspruch 1, wobei der Sensor ein Spannungssensor (530) ist, der parallel mit dem hochohmigen Widerstand (550) verbunden ist, um eine an den hochohmigen Widerstand angelegte Spannung zu messen.

4. Batterieschutzeinrichtung nach Anspruch 1, die weiter ein Batterieverwaltungssystem (BMS) einschließt, wobei die Steuereinheit in dem Batterieverwaltungssystem (BMS), das einen Batteriezustand verwaltet, eingeschlossen ist.

5. Batterieschutzeinrichtung nach Anspruch 2, wobei die Steuereinheit so ausgebildet ist, dass sie bestimmt, dass mindestens eine der ersten Schmelzsicherung und der zweiten Schmelzsicherung durchgebrannt ist, wenn der vom Stromsensor gemessene Stromwert Null ist.

6. Batterieschutzeinrichtung nach Anspruch 2, wobei die Steuereinheit so ausgebildet ist, dass sie unter Verwendung des vom Stromsensor gemessenen Stromwerts und des Widerstandswerts des hochohmigen Widerstands eine von der Batterie bereitgestellte Systemspannung berechnet.

7. Batterieschutzeinrichtung nach Anspruch 3, wobei mindestens eine der Steuereinheit so ausgebildet ist, dass sie bestimmt, dass die erste Schmelzsicherung und die zweite Schmelzsicherung durchgebrannt sind, wenn der durch den Spannungssensor gemessene Spannungswert Null ist.

8. Batterieschutzeinrichtung nach Anspruch 3, wobei die Steuereinheit so ausgebildet ist, dass sie die von dem Spannungssensor gemessene Spannung als eine von der Batterie bereitgestellte Systemspannung bestimmt.

## Revendications

1. Appareil de protection de batterie (500) dans un système de stockage d'énergie incluant une batterie, l'appareil de protection de batterie comprenant :
un premier fusible conçu pour être connecté à une borne positive d'une batterie ;
un deuxième fusible conçu pour être connecté à une borne négative de la batterie ;
**caractérisé par** :
un premier contacteur principal configuré pour commander une connexion entre le premier fusible et une borne positive d'un bus CC ;
un deuxième contacteur principal configuré pour commander une connexion entre le deuxième fusible et une borne négative du bus CC ;
une résistance de forte valeur (550) connectée au premier fusible et au deuxième fusible et disposée en parallèle avec la batterie ; dans lequel la résistance de forte valeur (550) est disposée entre un point de contact du premier fusible et le premier contacteur principal et un point de contact entre le deuxième fusible et le deuxième contacteur principal ;
un capteur configuré pour mesurer un courant circulant à travers la résistance de forte valeur ou une tension appliquée à la résistance de forte valeur ; et
une unité de commande configurée pour déterminer si l'un quelconque parmi le premier fusible et le deuxième fusible est grillé à partir du courant mesuré ou de la tension mesurée,
dans lequel la résistance de la résistance de forte valeur (550) est configurée pour être telle que des fonctions spécifiques au système de charge et de décharge de la batterie ne soient pas affectées de manière significative par la résistance de forte valeur (550).

2. Appareil de protection de batterie selon la revendication 1, dans lequel le capteur est un capteur de courant (520) positionné entre la résistance de forte valeur et le premier fusible et connecté en série avec la résistance de forte valeur (550) ou positionné entre la résistance de forte valeur et le deuxième fusible et connecté en série avec la résistance de forte valeur.

3. Appareil de protection de batterie selon la revendication 1, dans lequel le capteur est un capteur de tension (530) connecté en parallèle avec la résistance de forte valeur (550) pour mesurer une tension appliquée à la résistance de forte valeur.

4. Appareil de protection de batterie selon la revendication 1, incluant en outre un système de gestion de batterie (BMS), dans lequel l'unité de commande est incluse dans le système de gestion de batterie (BMS) qui gère un état de la batterie.

5. Appareil de protection de batterie selon la revendication 2, dans lequel l'unité de commande est configurée pour déterminer qu'au moins un parmi le premier fusible et le deuxième fusible est grillé lorsque la valeur de courant mesurée par le capteur de courant est nulle.

6. Appareil de protection de batterie selon la revendication 2, dans lequel l'unité de commande est configurée pour calculer une tension du système fournie par la batterie en utilisant la valeur de courant mesurée par le capteur de courant et la valeur de résistance de la résistance de forte valeur.

7. Appareil de protection de batterie selon la revendication 3, dans lequel l'unité de commande est configurée pour déterminer qu'au moins l'un parmi le premier fusible et le deuxième fusible sont grillés lorsque la valeur de tension mesurée par le capteur de tension est nulle.

8. Appareil de protection de batterie selon la revendication 3, dans lequel l'unité de commande est configurée pour déterminer la tension mesurée par le capteur de tension comme une tension de système fournie par la batterie.
